# FASCICULE DE BREVET EUROPEEN

(11) **EP 1 811 567 B1**
(45) Date de publication et mention de la délivrance du brevet: **23.12.2015**
(21) Numéro de dépôt: 07354005.6
(22) Date de dépôt: 19.01.2007
(51) Int. Cl.: H01L 27/06

(54) **Circuit intégré tridimensionnel de type C-MOS et procédé de fabrication**
Dreidimensionaler integrierter CMOS-Schaltkreis und Herstellungsverfahren
Three-dimensional CMOS integrated circuit and manufacturing method

(30) Priorité: 23.01.2006 FR 0600577
(43) Date de publication de la demande: 25.07.2007
(73) Titulaire: Commissariat à l'Énergie Atomique et aux Énergies Alternatives, 75015 Paris (FR)
(72) Inventeur: Joly, Jean-Pierre, 38120 Saint Egrève (FR); Faynot, Olivier, 38170 Seyssinet-Pariset (FR); Clavelier, Laurent, 38700 Voiron (FR)
(74) Mandataire: Hecké, Gérard

(56) Documents cités:
- US-A1- 2004 065 884
- US-A1- 2004 065 927
- US-A1- 2004 178 826

## Description

### Domaine technique de l'invention

L'invention concerne un circuit intégré tridimensionnel de type CMOS formé dans un substrat hybride et comportant des transistors de types de conductivité différents, formés respectivement dans des première et seconde couches semi-conductrices disposées sur deux niveaux superposés, respectivement inférieur et supérieur.

L'invention concerne également un procédé de fabrication d'un tel circuit.

### État de la technique

La recherche de rapidité dans les circuits intégrés de type C-MOS implique une diminution des temps de commutation des transistors ainsi que des temps de propagation dans les interconnexions du circuit.

La diminution des temps de commutation peut être obtenue par une réduction de la longueur des canaux des transistors ainsi que par une augmentation de la mobilité des porteurs dans le semi-conducteur. L'augmentation de la mobilité des porteurs peut être obtenue par l'utilisation de deux couches de semi-conducteurs ayant chacun une mobilité améliorée, respectivement pour les électrons et pour les trous, à la place du silicium massif standard, d'orientation (100), non contraint, classiquement utilisé à la fois pour les transistors n-MOS et p-MOS du circuit. L'augmentation de la mobilité, pour les électrons dans les transistors n-MOS et pour les trous dans les transistors p-MOS, peut être obtenue par un choix d'orientation cristalline, la mise en contrainte des semi-conducteurs, un changement de matériau ou une combinaison de plusieurs de ces paramètres. Ainsi, une contrainte en tension dans le silicium améliore la mobilité des électrons, l'orientation de surface (110) procure une meilleure mobilité des trous mais une moins bonne mobilité des électrons que l'orientation (100), le germanium procure une meilleure mobilité des trous que le silicium, etc. Par ailleurs, les diélectriques de grille et les matériaux d'électrode de grille sont, de préférence, adaptés aux deux types de transistors, surtout si ceux-ci sont réalisés dans deux couches de natures, de contraintes ou d'orientations différentes.

Il est ainsi connu d'utiliser pour la fabrication d'un circuit de type C-MOS un substrat hybride, c'est-à-dire un substrat sur lequel sont formées deux types de couches de semi-conducteur.

Actuellement, il existe essentiellement trois méthodes de fabrication d'un substrat hybride.

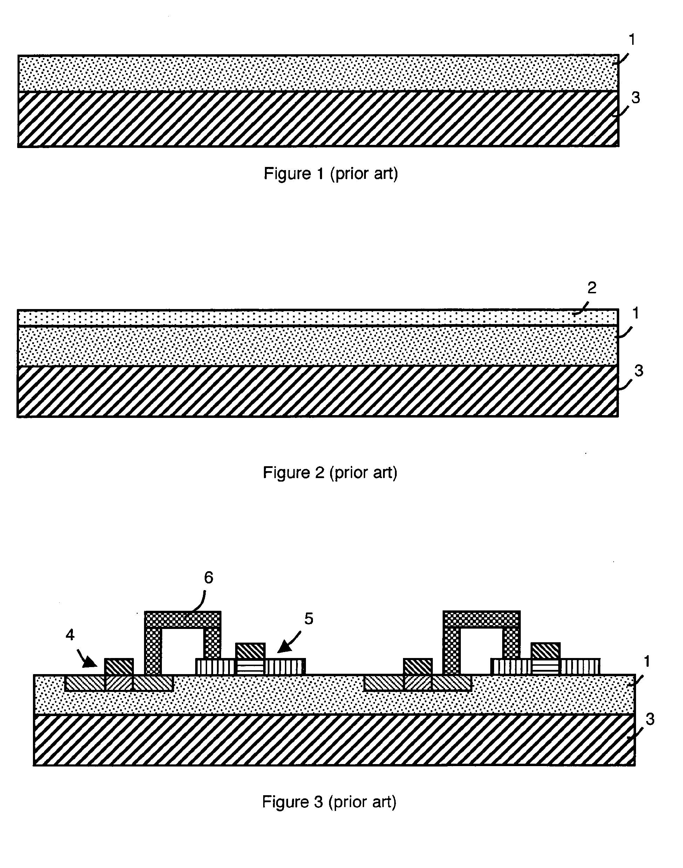

Une première méthode, illustrée aux figures 1 à 3, utilise l'hétéroépitaxie. Des couches épitaxiales 1 et 2, respectivement destinées à servir de base aux transistors n-MOS et p-MOS, sont formées successivement sur un substrat 3. Typiquement, on fait croître, sur un substrat 3 de silicium d'orientation (100), une première couche tampon d'alliage SiGe, par CVD, de composition graduellement croissante jusqu'à obtenir une couche de germanium pur relaxé en surface. Sur cette couche 1, on fait croître une fine couche 2 de silicium contraint. Après élimination sélective locale de la couche 2 de silicium contraint, les transistors p-MOS 4 sont formés dans la couche 1 de germanium et les transistors n-MOS 5 dans la couche 2 de silicium contraint. Des interconnexions 6 entre les transistors p-MOS et n-MOS, sont ensuite formées, par exemple comme représenté schématiquement sur la figure 3, entre le drain et la source des transistors p-MOS et n-MOS.

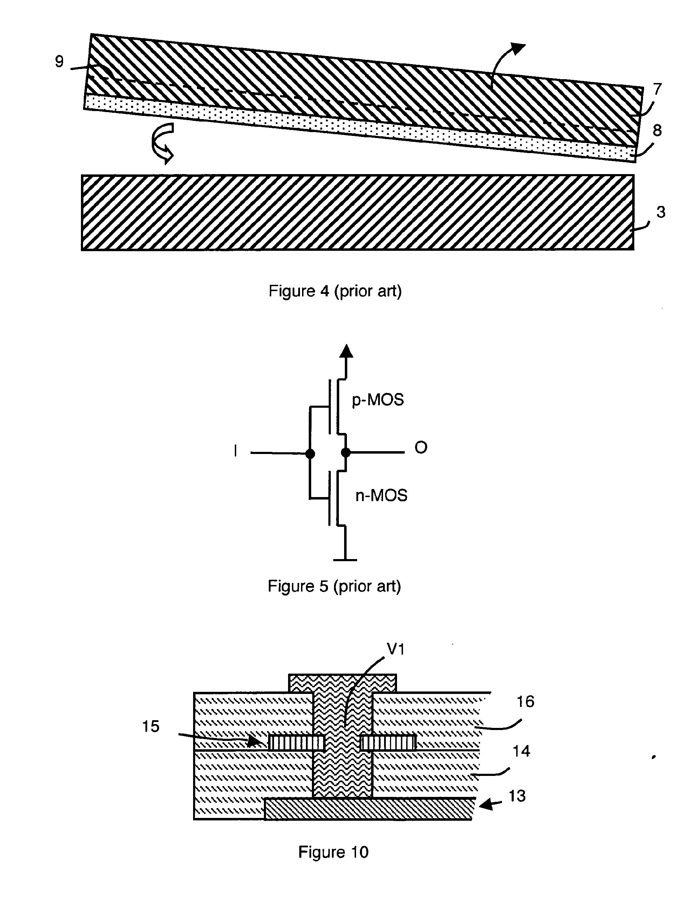

Une seconde méthode, notamment décrite dans l'article "High Performance CMOS Fabricated on Hybrid Substrate With Different Crystal Orientations", de Yang et al., dans IEDM 03-453, p.18.7.1-18.7.2, et illustrée schématiquement à la figure 4, utilise le transfert de couche par collage moléculaire. Un substrat de silicium 7, d'orientation donnée, par exemple (110), est oxydé (couche isolante 8), puis transféré par la technologie Smart Cut® (implantation d'hydrogène, collage et détachement à l'emplacement de la ligne pointillée 9) sur un substrat de silicium 3 d'orientation différente, par exemple (100). La couche supérieure (substrat 7 sur isolant 8) amincie constitue ainsi une couche de silicium sur isolant (SOI), dans laquelle sont ultérieurement formés les transistors p-MOS. Cette couche est gravée pour exposer la surface du substrat 3 aux emplacements prévus pour les transistors n-MOS. On fait ensuite croître sélectivement, par homo-épitaxie localisée dans les orifices ainsi formés, du silicium d'orientation (100), dans lequel seront ultérieurement formés les transistors n-MOS. Dans l'article précité, les transistors n-MOS et p-MOS sont ainsi formés au même niveau, dans des substrats de silicium d'orientations différentes.

Une troisième méthode, non représentée, utilise des déformations élastiques localisées. Les transistors n-MOS et p-MOS sont alors réalisés dans un même matériau (par exemple Si), dans des zones adjacentes, respectivement constituées par des couches de forte contrainte en tension et de forte contrainte en compression.

Actuellement, la diminution du temps de propagation dans les interconnexions est essentiellement obtenue par une diminution de la résistivité des métaux (utilisation de cuivre) et/ou de la permittivité des diélectriques utilisés dans les interconnexions. La réduction de la permittivité des diélectriques implique une augmentation de leur porosité, provoquant une forte dégradation de leurs propriétés mécaniques et thermiques. Il est donc difficile d'aller au-delà dans cette voie.

Une diminution du temps de propagation dans les interconnexions a également été obtenue par une intégration tridimensionnelle (intégration 3D) des circuits, les transistors étant empilés les uns sur les autres.

La demande de brevet US 2004/0145399 décrit un circuit CMOS tridimensionnel constitué par la superposition d'un transistor p-MOS sur un transistor n-MOS (ou inversement). La couche de semi-conducteur supérieure est formée par épitaxie localisée en utilisant comme germe un via semi-conducteur, lui-même formé par croissance épitaxiale du semi-conducteur inférieur. La source et le drain du transistor n-MOS sont verticalement alignés respectivement avec la source et le drain du transistor p-MOS. Il en va de même de leurs grilles. Des interconnexions sont prévues, notamment pour connecter les deux transistors de la manière représentée à la figure 5, pour former un inverseur. Les deux transistors sont ainsi connectés en série entre une borne d'alimentation et la masse, le point commun aux deux transistors en série constituant la sortie S de l'inverseur, et leurs grilles sont connectées à l'entrée E de l'inverseur.

Dans le mode de réalisation décrit dans l'article "3-D ICs : A Novel Chip Design for Improving Deep-Submicrometer Interconnect Performance and Systems-on-Chip Integration", de Banerjee et al., dans Proceedings of the IEEE, vol.89, n°5, p. 602-630, de mai 2001, des transistors ou des blocs de circuits complets, incluant leurs métallisations et une partie des interconnexions, sont réalisés séparément sur au moins deux substrats. Les blocs sont ensuite alignés et collés les uns au-dessus des autres. L'un des substrats est éliminé et les différents niveaux sont interconnectés par des techniques connues de métallisation en surface. La densité de connexion d'un niveau à l'autre est notamment limitée par les technologies d'alignement actuellement disponibles (au mieux de l'ordre de 1 à 2µm).

L'article "Three-Dimensional Metal Gate-High-K-GOI CMOSFETS on 1-Poly-6-Metal 0.18µm Si Devices", de YU et al., dans IEEE Electron Device Letters, vol.26, n°2, p.118-120, de février 2005, décrit une intégration 3D de CMOS formés dans une couche de germanium sur isolant (GeOI) et de CMOS formés dans du silicium. La superposition est réalisée par report par la technologie Smart Cut® (implantation d'hydrogène, collage et détachement) d'une couche de germanium au-dessus de multicouches d'interconnexions en cuivre des circuits CMOS préalablement réalisés dans le silicium, au premier niveau. Des circuits CMOS sont ensuite formés dans le germanium, au second niveau, sans affecter les structures sous-jacentes. Un enseignement sensiblement équivalent est présent dans le document US2004/0065884.

### Objet de l'Invention

L'invention a pour but un circuit tridimensionnel ne présentant pas les inconvénients des circuits connus, ainsi que son procédé de fabrication. Plus particulièrement, l'invention a pour but d'optimiser la fabrication d'un tel circuit.

Selon l'invention, ce but est atteint par un circuit selon les revendications annexées et plus particulièrement par le fait que les transistors de type n-MOS sont formés, au niveau inférieur, dans la première couche semi-conductrice, en silicium d'orientation (100), les transistors de type p-MOS étant formés, au niveau supérieur, dans la seconde couche semi-conductrice, en germanium d'orientation (110).

Un procédé de fabrication d'un tel circuit est caractérisé par le fait qu'il comporte successivement :
- la fabrication d'un premier bloc comportant les transistors de type n-MOS formés dans une couche semi-conductrice en silicium d'orientation (100),
- le transfert sur le premier bloc d'une couche semi-conductrice en germanium d'orientation (110) et
- la fabrication des transistors de type p-MOS dans la couche semi-conductrice en germanium, à une température n'affectant pas les transistors formés dans la couche semi-conductrice en silicium.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 à 3 illustrent la réalisation d'un substrat hybride selon l'art antérieur par hétéroépitaxie.
La figure 4 illustre la formation d'un substrat hybride selon l'art antérieur par transfert de couche.
La figure 5 représente le schéma électrique classique d'un inverseur constitué par des transistors p-MOS et n-MOS.
Les figures 6 à 8 illustrent un mode de réalisation particulier d'un circuit selon l'invention, respectivement en perspective, en vue de dessus et en coupe selon A-A.
La figure 9 illustre un mode particulier de fabrication d'un circuit selon l'invention.
La figure 10 illustre schématiquement un mode particulier de réalisation d'un via multiple d'un circuit selon l'invention.

### Description de modes particuliers de réalisation

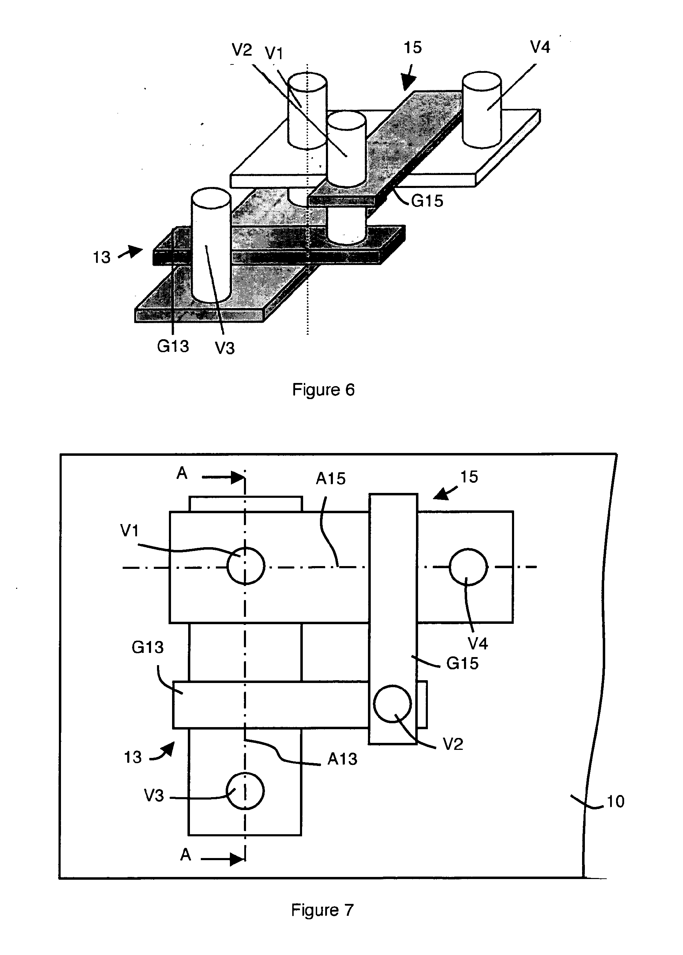

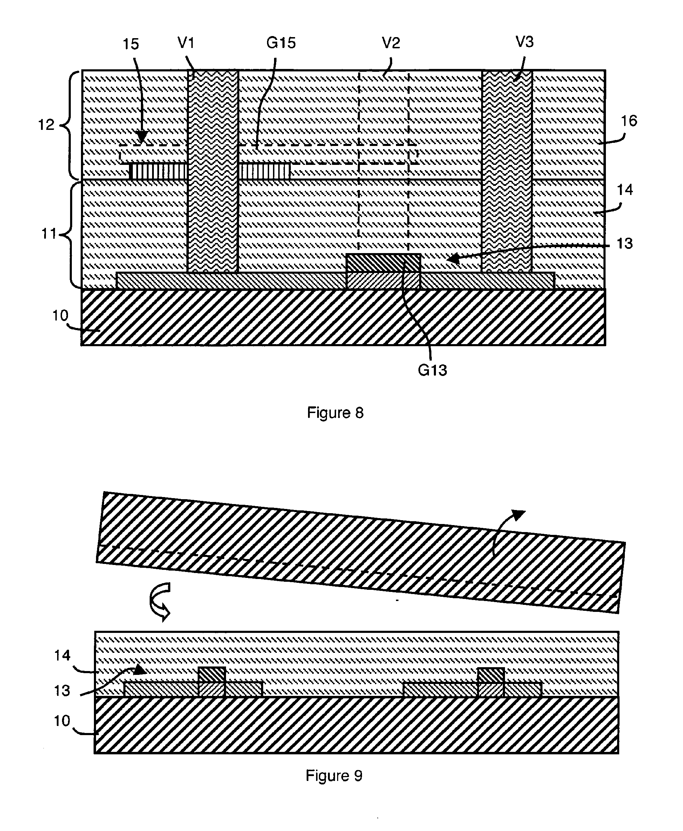

Le circuit tridimensionnel représenté aux figures 6 à 8, comporte, sur un substrat 10 (non représenté dans la vue en perspective de la figure 6), deux niveaux superposés, respectivement inférieur 11 et supérieur 12 (fig.8).

Le niveau inférieur 11 comporte les transistors 13 de type n-MOS, formés dans une première couche semi-conductrice. Celle-ci est en silicium ayant une orientation adaptée à la fabrication de transistors de type n-MOS. Le niveau inférieur est complété par une couche diélectrique inférieure 14 (non représentée dans la vue en perspective de la figure 6), déposée sur les transistors 13 et le substrat 10 et dont la face libre est aplanie.

Le niveau supérieur 12 est disposé sur la face libre aplanie de la couche diélectrique inférieure 14. Il comporte les transistors 15 de type p-MOS, formés dans une seconde couche semi-conductrice et recouverts par une couche diélectrique supérieure 16 (non représentée dans la vue en perspective de la figure 6). La seconde couche semi-conductrice est en germanium ayant une orientation différente, adaptée à la fabrication de transistors de type p-MOS. La couche en germanium est, de préférence, en germanium pur, mais peut éventuellement être constituée par du germanium très concentré, par exemple par un alliage SiGe comportant plus de 80%, de préférence plus de 90%, de germanium. Les propriétés physiques, notamment la largeur de la bande interdite, d'un tel alliage sont en effet comparables à celles du germanium pur.

La réalisation des transistors p-MOS dans la couche de germanium peut se faire à une température de l'ordre de 400 à 600°C, n'affectant pas les transistors n-MOS 13, formés dans le silicium au niveau inférieur, plus particulièrement lors des étapes de fabrication nécessitant une forte température, comme l'activation des dopants ou la fabrication de l'isolant de grille.

Le choix de l'ordre d'empilement des transistors des deux niveaux n'est pas aléatoire, mais tient compte des températures maximales associées aux matériaux, notamment aux matériaux semi-conducteurs. En effet, le budget thermique de réalisation d'un transistor de type MOS dans le germanium est inférieur à environ 600°C, tandis que le budget thermique de réalisation d'un transistor de type MOS dans le silicium est plus élevé, généralement supérieur à 800°C (typiquement de l'ordre de 800°C à 1000°C).

Les transistors 13 du niveau inférieur 11, qui sont de type n-MOS, sont formés dans une couche de silicium d'orientation (100), tandis que les transistors 15 du niveau supérieur 12, qui sont de type p-MOS, sont, réalisés dans une couche de germanium d'orientation (110).

Au moins l'une des première et seconde couches semi-conductrices peut avoir une contrainte adaptée à la fabrication des transistors correspondants. Ainsi, la couche de silicium est, de préférence, contrainte en tension et la couche de germanium en compression. La seconde couche semi-conductrice est, de préférence, en germanium contraint biaxialement. Le germanium est, de préférence, monocristallin.

La couche de silicium, d'orientation (100), du niveau inférieur 11 possède une très bonne mobilité pour les électrons, tandis que la couche en germanium, d'orientation (110), du niveau supérieur 12 offre une excellente mobilité pour les trous. Les matériaux semi-conducteurs utilisés sont donc optimums pour les deux types de transistors.

La couche de silicium, éventuellement contraint, du niveau inférieur 11 peut être réalisée par tout procédé connu approprié.

Dans une première variante de réalisation, cette couche est formée sur le substrat 10 en silicium, d'orientation (100), par hétéroépitaxie d'une couche de SiGe relaxée, de composition graduellement croissante en germanium, jusqu'à obtention de la composition désirée. Puis une fine couche de silicium, d'épaisseur inférieure à l'épaisseur critique (non relaxé) est formée par hétéroépitaxie sur la couche en SiGe. La composition désirée de la couche de SiGe comporte typiquement de l'ordre de 20 à 30% de germanium dans le silicium, ce qui permet une augmentation importante de la mobilité dans la couche de silicium contraint, élaborée ensuite.

Dans une seconde variante de réalisation, la couche de silicium contraint est réalisée par transfert par le procédé Smart Cut® (implantation d'hydrogène, collage et détachement) d'une couche de surface contenant la couche de silicium contraint et tout ou partie de la couche SiGe sur une structure de type SOI, comportant un substrat de silicium et une couche isolante. La couche de SiGe est alors éliminée par attaque chimique sélective pour ne laisser que la couche de silicium contraint.

Dans les deux variantes, les transistors 13, de type n-MOS, sont ensuite réalisés, de manière classique, dans la couche de silicium d'orientation (100). Cette réalisation comporte les étapes successives suivantes : isolation latérale entre transistors par gravure et dépôt de diélectriques, dépôt d'au moins un diélectrique de grille, dépôt et définition de motifs dans un matériau conducteur constituant l'électrode de grille G13, définition d'espaceurs par dépôt de diélectrique et gravure sèche, dopage par implantation ionique, activation des dopants n de la source et du drain par recuit et réalisation des siliciures, par exemple en NiSi. Le diélectrique 14 du niveau inférieur 11 est ensuite déposé sur le substrat 10 et les transistors 13, puis planarisé, terminant ainsi la fabrication du niveau inférieur 11.

Dans un mode de réalisation préférentiel, une couche de germanium d'orientation (110), issue d'un substrat contenant ce matériau, est ensuite transférée sur le niveau inférieur 11, par collage moléculaire et amincissement ou par le procédé Smart Cut® (implantation d'hydrogène, collage et détachement), comme illustré à la figure 9. Ce type de substrat peut être un substrat monocristallin de germanium, d'orientation (110), élaboré par les procédés classiques (par exemple Czochralski) ou un substrat de silicium d'orientation (110) sur lequel on a fait croître une première couche relaxée (sans contrainte), dite couche tampon, d'alliage SiGe de concentration graduellement croissante en germanium, puis une couche de germanium pur. La couche de germanium peut aussi être obtenue à partir d'un substrat GeOl que l'on colle et dont on supprime la couche support en silicium ainsi que la couche isolante (initialement l'oxyde enterré). On peut aussi obtenir cette couche de germanium par épitaxie en phase liquide (LPE : Liquid Phase Epitaxy), notamment après ouverture d'une cavité débouchant sur le substrat ayant dans ce cas une orientation (110) afin d'obtenir un germe de cristallisation orienté, suivie d'une étape de coupure du germe.

Les transistors 15, de type p-MOS, sont ensuite réalisés, de manière classique, dans la couche de germanium ainsi transférée sur le niveau inférieur 11. Cette réalisation comporte, comme précédemment, successivement l'isolation latérale entre transistors par gravure et dépôt de diélectriques, le dépôt d'au moins un diélectrique de grille, le dépôt et la définition de motifs dans un matériau conducteur constituant l'électrode de grille G15, la définition d'espaceurs par dépôt de diélectrique et gravure sèche, le dopage par implantation ionique, activation des dopants p de la source et du drain par recuit et réalisation des siliciures. L'utilisation d'une couche semi-conductrice en germanium, de préférence monocristallin, permet de réaliser les transistors 15 à des températures aussi faibles que 400-600°C n'affectant pas les transistors 13 déjà réalisés au niveau inférieur 11. Ces températures sont, en particulier, compatibles avec la stabilité des siliciures des transistors du niveau inférieur. En effet, les siliciures actuellement utilisés (NiSi) sont stables jusqu'à environ 600°C, par adjonction de quelques pourcents de Pt ou Pd.

Comme représenté à la figure 8, le diélectrique 16 du niveau supérieur 12 est ensuite déposé sur le diélectrique 14 du niveau inférieur 11 et sur les transistors 15, puis éventuellement planarisé, terminant ainsi la fabrication du niveau supérieur 12.

La réalisation d'un premier niveau de connexions et d'interconnexions du circuit commence ensuite par la gravure et la métallisation de vias à travers les différentes couches du circuit. Des vias simples V3 et V4, respectivement associé aux transistors 13 et 15, sont gravés à travers les diélectriques 14 et/ou 16 recouvrant les transistors 13 et 15, avec arrêt sur la couche semi-conductrice du transistor correspondant. Des vias multiples V1 et V2 interconnectent un transistor n-MOS 13 du niveau inférieur à un transistor p-MOS 15 associé du niveau supérieur pour former un circuit CMOS.

Les vias sont réalisés par gravure sèche, de préférence séquentiellement avec plusieurs niveaux de lithographie, de manière à contrôler les risques de surgravure susceptibles d'apparaître si l'on procède en une seule étape. Le profil de gravure des vias multiples V1 et V2, qui partent respectivement du drain ou de la source et de la grille du transistor 13 et traversent successivement le diélectrique 14, respectivement la source ou le drain et la grille du transistor 15 associé et le diélectrique 16, est, de préférence adapté de manière à maximiser la surface de gravure entre le métal du via et le matériau du transistor. Ceci peut, par exemple, être réalisé par une légère surgravure des diélectriques 14 et 16 par rapport aux matériaux du transistor 15 qui sont traversés par le via, comme représenté à la figure 10 pour le via V1. L'orifice du via V1 est ainsi plus large au niveau des diélectriques 14 et 16 qu'au niveau de la couche semi-conductrice du transistor 15 qu'il traverse.

Comme représenté à la figure 10, un second niveau d'interconnexion est formé sur le diélectrique 16, par exemple pour connecter les vias V1 à V4, respectivement aux bornes de sortie S, d'entrée E et d'alimentation de l'inverseur ou à d'autres éléments (non représentés) du circuit.

Le procédé de fabrication selon l'invention comporte ainsi successivement au moins :
- la fabrication d'un premier bloc comportant les transistors (13) de type n-MOS formés dans une couche semi-conductrice en silicium ayant une orientation adaptée à la fabrication de transistors (13) de type n-MOS,
- le transfert sur le premier bloc d'une couche semi-conductrice en germanium ayant une orientation adaptée à la fabrication de transistors (15) de type p-MOS et
- la fabrication des transistors (15) de type p-MOS dans la couche semi-conductrice en germanium, à une température n'affectant pas les transistors formés dans la couche semi-conductrice en silicium.

Dans le mode particulier de réalisation décrit ci-dessus, le procédé de fabrication comporte successivement :
- la fabrication des transistors 13, de type n-MOS, du premier niveau ou niveau inférieur 11, dans une couche en silicium contraint en tension, d'orientation (100),
- le dépôt et la planarisation d'une couche diélectrique 14, au premier niveau,
- la formation de la seconde couche semi-conductrice, en germanium monocristallin d'orientation (110), contraint en compression,
- la fabrication des transistors 15, de type p-MOS, du second niveau ou niveau supérieur 12,
- le dépôt d'une seconde couche diélectrique 16, au second niveau,
- la formation de vias multiples verticaux (V1, V2), constituant les interconnexions entre les transistors (13, 15) de niveaux différents, et de vias simples verticaux (V3, V4), constituant diverses connexions du circuit.

Les transistors 13 et 15 des niveaux inférieur et supérieur sont, de préférence, disposés de manière à ce que les zones de ces transistors destinées à être interconnectées se recouvrent. Ainsi, par exemple, sur les figures 6 à 8, pour fabriquer un inverseur selon la figure 5, les axes longitudinaux respectifs A13 et A15 d'un transistor 13 du niveau inférieur et d'un transistor 15 du niveau supérieur, passant respectivement par le drain, le canal et la source du transistor considéré, sont perpendiculaires.

Dans certains cas, notamment pour résoudre des problèmes de connectique, les transistors sont asymétriques, le drain ou la source destinée à être connectée à la source ou au drain du transistor associé du niveau adjacent étant prolongé longitudinalement, de manière à former une première zone de recouvrement, dans laquelle est formée une première interconnexion des transistors de niveaux différents, constituant la sortie S de l'inverseur. Cette première interconnexion peut alors être constituée par un premier via vertical V1. Simultanément, les grilles G13 et G15 des transistors, classiquement formées au-dessus du canal correspondant, sont prolongées, perpendiculairement à leurs axes longitudinaux respectifs, de manière à former une seconde zone de recouvrement à une de leurs extrémités. Une seconde interconnexion des transistors de niveaux différents, constituant l'entrée E de l'inverseur, peut alors être constituée par un second via vertical V2. Ces interconnexions ou vias multiples connectent ainsi directement un transistor avec le transistor complémentaire associé du niveau adjacent.

Des troisième et quatrième vias verticaux V3 et V4 sont respectivement formés aux extrémités des transistors 13 et 15 opposés à la première zone de recouvrement. Ces connexions ou vias simples peuvent alors servir de connexions du circuit, notamment aux bornes d'alimentation de l'inverseur.

Toutes les interconnexions du circuit CMOS sont ainsi réalisées par l'intermédiaire de vias verticaux, interconnectant directement les parties à connecter de deux transistors associés de niveaux différents et permettant leur connexion à d'autres éléments du circuit. Elles peuvent être formées en même temps que les connexions simples connectant un transistor à d'autres éléments du circuit que le transistor complémentaire de niveau adjacent.

Cette disposition particulière des transistors complémentaires associés des deux niveaux superposés permet d'obtenir un assemblage 3D très dense, avec une densification du nombre de transistors par unité de surface et une diminution de la longueur moyenne des connexions.

Les températures utilisées lors de la fabrication de la couche semi-conductrice en germanium étant inférieures à 700°C, les vias peuvent être réalisées avant de réaliser la couche de germanium, ce qui est notamment plus facile à mettre en oeuvre qu'après le collage du Ge.

Le matériau d'électrode de grille de chaque type de transistor (N et P) doit être adapté au travail de sortie du transistor correspondant. Dans le cas d'une technologie planaire, on dépose typiquement un premier matériau pour former des premières grilles associées à l'un des deux types de transistors, puis il est nécessaire de graver le matériau pour pouvoir former les secondes grilles associées à l'autre type de transistors. Cette étape de gravure supplémentaire n'est pas nécessaire dans le cas de la technologie tridimensionnelle selon l'invention.

## Revendications

1. Circuit intégré tridimensionnel de type CMOS formé dans un substrat hybride et comportant des transistors de types de conductivité différents, formés respectivement dans des première et seconde couches semi-conductrices disposées sur deux niveaux superposés, respectivement inférieur et supérieur, circuit **caractérisé en ce que** les transistors (13) de type n-MOS sont formés, au niveau inférieur, dans la première couche semi-conductrice, en silicium d'orientation (100), les transistors (15) de type p-MOS étant formés, au niveau supérieur, dans la seconde couche semi-conductrice, en germanium d'orientation (110).

2. Circuit selon la revendication 1, **caractérisé en ce qu'**au moins l'une des première et seconde couches semi-conductrices a une contrainte adaptée à la fabrication des transistors correspondants.

3. Circuit selon la revendication 2, **caractérisé en ce que** la première couche semi-conductrice est en silicium contraint en tension.

4. Circuit selon l'une des revendications 2 et 3, **caractérisé en ce que** la seconde couche semi-conductrice est en germanium contraint en compression.

5. Circuit selon la revendication 4, **caractérisé en ce que** la seconde couche semi-conductrice est en germanium contraint biaxialement.

6. Circuit selon l'une quelconque des revendications 1 à 5, **caractérisé en ce que** le germanium est monocristallin.

7. Circuit selon l'une quelconque des revendications 1 à 6, **caractérisé en ce que** les axes longitudinaux (A13, A15) d'un transistor (13) de type n-MOS et d'un transistor (15) de type p-MOS associé sont perpendiculaires, de manière à former au moins une zone de recouvrement, dans laquelle est formée une interconnexion (V1, V2) desdits transistors associés.

8. Circuit selon la revendication 7, **caractérisé en ce que** le drain ou la source d'un transistor (13) de type n-MOS étant destinée à être connecté à la source ou au drain d'un transistor (15) de type n-MOS associé, ils sont prolongés longitudinalement, de manière à former une première zone de recouvrement, dans laquelle est formée une première interconnexion (V1) des transistors.

9. Circuit selon la revendication 8, **caractérisé en ce qu'**il comporte des connexions verticales (V3, V4) formées aux extrémités des transistors (13, 15) opposées à la première zone de recouvrement.

10. Circuit selon l'une quelconque des revendications 7 à 9, **caractérisé en ce que** les grilles (G13, G15) des transistors (13, 15) sont prolongées, perpendiculairement à leurs axes longitudinaux respectifs (A13, A15), de manière à former, à une de leurs extrémités, une seconde zone de recouvrement, dans laquelle est formée une seconde interconnexion (V2) des transistors.

11. Procédé de fabrication d'un circuit intégré tridimensionnel de type CMOS formé dans un substrat hybride et comportant des transistors de types de conductivité différents, formés respectivement dans des première et seconde couches semi-conductrices superposées, procédé **caractérisé en ce qu'**il comporte successivement :
- la fabrication d'un premier bloc comportant les transistors (13) de type n-MOS formés dans une première couche semi-conductrice en silicium d'orientation (100),
- le transfert sur le premier bloc d'une deuxième couche semi-conductrice en germanium d'orientation (110) et
- la fabrication des transistors (15) de type p-MOS dans la deuxième couche semi-conductrice en germanium d'orientation (110), à une température n'affectant pas les transistors formés dans la première couche semi-conductrice en silicium.

12. Procédé selon la revendication 11, **caractérisé en ce que** la température de fabrication des transistors (15) de type p-MOS dans la couche semi-conductrice en germanium est de l'ordre de 400 à 600°C.

13. Procédé selon l'une des revendications 11 et 12, **caractérisé en ce que** le transfert de la couche semi-conductrice en germanium sur le premier bloc est réalisé par collage moléculaire et amincissement.

14. Procédé selon l'une des revendications 11 et 12, **caractérisé en ce que** le transfert de la couche semi-conductrice en germanium sur le premier bloc est réalisé par report par implantation d'hydrogène, collage et détachement.

15. Procédé selon l'une des revendications 11 et 12, **caractérisé en ce que** le transfert de la couche semi-conductrice en germanium sur le premier bloc est réalisé par épitaxie en phase liquide après ouverture d'une cavité débouchant sur le substrat ayant une orientation (110) afin d'obtenir un germe de cristallisation orienté.

16. Procédé selon l'une quelconque des revendications 11 à 15, **caractérisé en ce qu'**il comporte la formation de vias multiples (V1, V2) verticaux, constituant les interconnexions entre les transistors associés de type n-MOS (13) et de type p-MOS (15) de niveaux différents.

17. Procédé selon l'une quelconque des revendications 11 à 16, **caractérisé en ce qu'**il comporte la formation de vias simples (V3, V4) verticaux, constituant diverses connexions du circuit.

18. Procédé selon l'une quelconque des revendications 11 à 17, **caractérisé en ce qu'**il comporte la formation de vias avant la réalisation de la couche semi-conductrice en germanium.

## Patentansprüche

1. Dreidimensionaler integrierter Schaltkreis vom Typ CMOS, der in einem Hybridsubstrat ausgebildet ist und Transistoren mit unterschiedlichen Leitfähigkeitstypen umfasst, die in einer ersten bzw. einer zweiten Halbleiterschicht gebildet sind, welche auf zwei übereinander liegenden Ebenen, unteren bzw. oberen, angeordnet sind, Schaltkreis, der **dadurch gekennzeichnet ist, dass** die Transistoren (13) vom Typ n-MOS auf der unteren Ebene in der ersten Halbleiterschicht aus Silizium der Orientierung (100) gebildet sind und dass die Transistoren (15) vom Typ p-MOS auf der oberen Ebene in der zweiten Halbleiterschicht aus Germanium der Orientierung (110) gebildet sind.

2. Schaltkreis nach Anspruch 1, **dadurch gekennzeichnet, dass** wenigstens eine der ersten und zweiten Halbleiterschichten eine der Herstellung der entsprechenden Transistoren angepasste Spannung aufweist.

3. Schaltkreis nach Anspruch 2, **dadurch gekennzeichnet, dass** die erste Halbleiterschicht aus auf Zug beanspruchtem Silizium besteht.

4. Schaltkreis nach einem der Ansprüche 2 und 3, **dadurch gekennzeichnet, dass** die zweite Halbleiterschicht aus auf Druck beanspruchtem Germanium besteht.

5. Schaltkreis nach Anspruch 4, **dadurch gekennzeichnet, dass** die zweite Halbleiterschicht aus biaxial gespanntem Germanium besteht.

6. Schaltkreis nach einem der Ansprüche 1 bis 5, **dadurch gekennzeichnet, dass** das Germanium monokristallin ist.

7. Schaltkreis nach einem der Ansprüche 1 bis 6, dadurch gekennzeichet, dass die Längsachsen (A13, A15) eines Transistors (13) vom Typ n-MOS und eines zugeordneten Transistors (15) vom Typ p-MOS senkrecht sind, so dass sie wenigstens einen Überlappungsbereich bilden, in dem eine Zusammenschaltung (V1, V2) der zugeordneten Transistoren gebildet ist.

8. Schaltkreis nach Anspruch 7, **dadurch gekennzeichnet, dass**, da der Drain oder die Source eines Transistors (13) vom Typ n-MOS dazu bestimmt ist, an die Source oder den Drain eines zugeordneten Transistors (15) vom Typ n-MOS abgeschlossen zu werden, sie längs verlängert sind, um einen ersten Überlappungsbereich zu bilden, in dem eine erste Zusammenschaltung (V1) der Transistoren gebildet ist.

9. Schaltkreis nach Anspruch 8, **dadurch gekennzeichnet, dass** er vertikale Anschlüsse (V3, V4) umfasst, die an den von dem ersten Überlappungsbereich abgewandte Enden der Transistoren (13, 15) gebildet sind.

10. Schaltkreis nach einem der Ansprüche 7 bis 9, **dadurch gekennzeichnet, dass** die Gates (G13, G15) der Transistoren (13, 15) senkrecht zur ihren jeweiligen Längsachsen (A13, A15) verlängert sind, um an einem ihrer Enden einen zweiten Überlappungsbereich zu bilden, in dem eine zweite Zusammenschaltung (V2) der Transistoren gebildet ist.

11. Verfahren zur Herstellung eines dreidimensionalen integrierten Schaltkreises vom Typ CMOS, der in einem Hybridsubstrat ausgebildet ist und Transistoren mit unterschiedlichen Leitfähigkeitstypen umfasst, die in einer ersten bzw. einer zweiten Halbleiterschicht, welche übereinander liegen, gebildet sind, Verfahren, das **dadurch gekennzeichnet ist, dass** es nacheinander umfasst:
die Herstellung eines ersten Blocks, welcher die Transistoren (13) vom Typ n-MOS umfasst die in einer ersten Halbleiterschicht aus Silizium der Orientierung (100) ausgebildet sind,
- den Transfer einer zweiten Halbleiterschicht aus Germanium der Orientierung (110) auf den ersten Block und
- die Herstellung der Transistoren (15) vom Typ p-MOS in der zweiten Halbleiterschicht aus Germanium der Orientierung (110), bei einer Temperatur, die die in der ersten Halbleiterschicht aus Silizium ausgebildeten Transistoren nicht beeinträchtigt.

12. Verfahren nach Anspruch 11, **dadurch gekennzeichnet, dass** die Herstellungstemperatur der Transistoren (15) vom Typ p-MOS in der Halbleiterschicht aus Germanium in der Größenordnung von 400 bis 600 °C liegt.

13. Verfahren nach einem der Ansprüche 11 und 12, **dadurch gekennzeichnet, dass** der Transfer der Germanium-Halbleiterschicht auf den ersten Block durch molekulares Bonden und Verdünnung vollzogen wird.

14. Verfahren nach einem der Ansprüche 11 und 12, **dadurch gekennzeichnet, dass** der Transfer der Germanium-Halbleiterschicht auf den ersten Block durch Übertrag mittels Wasserstoffimplantation, Bonden und Abspalten vollzogen wird.

15. Verfahren nach einem der Anspruche 11 und 12, **dadurch gekennzeichnet, dass** der Transfer der Germanium-Halbleiterschicht auf den ersten Block durch Flüssigphasenepitaxie nach Öffnen eines auf das Substrat mit einer Orientierung (110) mündende Hohlraums vollzogen wird, um einen orientierten Kristallisationskeim zu erhalten.

16. Verfahren nach einem der Ansprüche 11 bis 15, **dadurch gekennzeichnet, dass** es die Bildung von mehrfachen vertikalen Durchkontaktierungen (V1, V2) umfasst, welche die Zusammenschaltungen zwischen den zugeordneten Transistoren vom Typ n-MOS (13) und vom Typ p-MOS (15) unterschiedlicher Ebenen bilden.

17. Verfahren nach einem der Ansprüche 11 bis 16, **dadurch gekennzeichnet, dass** es die Bildung von einfachen vertikalen Durchkontaktierungen (V3, V4), welche verschiedene Anschlüsse des Schaltkreises bilden, umfasst.

18. Verfahren nach einem der Ansprüche 11 bis 17, **dadurch gekennzeichnet, dass** es die Bildung von Durchkontaktierungen vor der Ausbildung der Germanium-Halbleiterschicht umfasst.

## Claims

1. A three-dimensional integrated CMOS circuit formed in a hybrid substrate and comprising transistors of different conductivity types, respectively formed in first and second semi-conducting layers located at two respectively bottom and top superposed levels, a circuit **characterised in that** the n-MOS transistors (13) are formed, at the bottom level, in the first semi-conducting layer, which is made of silicon with a (100) orientation, the p-MOS transistors (15) being formed, at the top level, in the second semi-conducting layer, which is made of germanium with a (110) orientation.

2. Circuit according to claim 1, **characterised in that** at least one of the first and second semi-conducting layers is strained in a suitable manner for fabrication of the corresponding transistors.

3. Circuit according to claim 2, **characterised in that** the first silicon semi-conducting layer is made of tension strained silicon.

4. Circuit according to any one of claims 2 and 3, **characterised in that** the second germanium semi-conducting layer is made of compression strained germanium.

5. Circuit according to claim 4, **characterised in that** the second germanium semi-conducting layer is made of biaxially strained germanium.

6. Circuit according to any one of claims 1 to 5, **characterised in that** the germanium is monocrystalline.

7. Circuit according to any one of claims 1 to 6, **characterised in that** the longitudinal axes (A13, A15) of an n-MOS transistor (13) and of an associated p-MOS transistor (15) are perpendicular so as to form at least one overlapping zone in which an interconnection (V1, V2) of said associated transistors is formed.

8. Circuit according to claim 7, **characterised in that** the drain or source of an n-MOS transistor (13) being designed to be connected to the source or drain of an associated n-MOS transistor (15), they are longitudinally extended so as to form a first overlapping zone in which a first interconnection (V1) of the transistors is formed.

9. Circuit according to claim 8, **characterised in that** it comprises vertical connections (V3, V4) formed at the ends of the transistors (13, 15) opposite the first overlapping zone.

10. Circuit according to any one of claims 7 to 9, **characterised in that** the gates (G13, G15) of the transistors (13, 15) are extended perpendicularly to their respective longitudinal axes (A13, A15) so as to form, at one end thereof, a second overlapping zone in which a second interconnection (V2) of the transistors is formed.

11. A method for producing a three-dimensional CMOS integrated circuit in a hybrid substrate and comprising transistors of different conductivity types respectively formed in superposed first and second semi-conducting layers, method **characterised in that** it comprises successively:
- fabrication of a first block comprising n-MOS transistors (13) formed in a first semi-conducting layer, made of silicon with a (100) orientation,
- transfer onto the first block of a second semi-conducting layer made of germanium with a (110) orientation and
- fabrication of p-MOS transistors (15) in the second semi-conducting layer made of germanium with a (110) orientation, at a temperature not affecting the transistors formed in the first silicon semi-conducting layer.

12. Method according to claim 11, **characterised in that** the fabrication temperature of the p-MOS transistors (15) in the germanium semi-conducting layer is about 400 to 600°C.

13. Method according to any one of claims 11 and 12, **characterised in that** the transfer of the germanium semi-conducting layer to the first block is performed by molecular bonding and thinning.

14. Method according to any one of claims 11 and 12, **characterised in that** the transfer of the germanium semi-conducting layer to the first block is performed by hydrogen implantation, bonding and detachment.

15. Method according to any one of claims 11 and 12, **characterised in that** the transfer of the germanium semi-conducting layer to the first block is performed by liquid phase epitaxy after a cavity has been opened out onto the substrate having a (110) orientation in order to obtain an oriented crystallization seed.

16. Method according to any one of claims 11 to 15, **characterised in that** it comprises the formation of vertical multiple vias (V1, V2) constituting the interconnections between the associated n-MOS transistors (13) and p-MOS transistors (15) of different levels.

17. Method according to any one of claims 11 to 16, **characterised in that** it comprises the formation of vertical single vias (V3, V4) constituting various connections of the circuit.

18. Method according to any one of claims 11 to 17, **characterised in that** it comprises the formation of vias before the germanium semi-conducting layer is produced.
